# EUROPÄISCHE PATENTSCHRIFT

(11) **EP 3 417 086 B1**
(45) Veröffentlichungstag und Bekanntmachung des Hinweises auf die Patenterteilung: **21.12.2022**
(21) Anmeldenummer: 17794653.0
(22) Anmeldetag: 18.10.2017
(51) Int. Cl.: C23C 14/34, C23C 14/35, H01J 37/34, C03C 17/36

(54) **VORRICHTUNG UND VERFAHREN ZUR HERSTELLUNG DEFINIERTER EIGENSCHAFTEN VON GRADIENTENSCHICHTEN IN EINEM SYSTEM MEHRLAGIGER BESCHICHTUNGEN BEI SPUTTER-ANLAGEN**
DEVICE AND METHOD FOR PRODUCING DEFINED PROPERTIES OF GRADIENT LAYERS IN A SYSTEM OF MULTILAYERED COATINGS IN SPUTTERING INSTALLATIONS
DISPOSITIF ET PROCÉDÉ D'ÉLABORATION DE PROPRIÉTÉS DÉFINIES DE COUCHES À GRADIENT D'UN SYSTÈME DE REVÊTEMENT MULTICOUCHE DANS LE CAS D'INSTALLATIONS DE PULVÉRISATION CATHODIQUE

(30) Priorität: 19.10.2016 DE 102016012460
(43) Veröffentlichungstag der Anmeldung: 26.12.2018
(73) Patentinhaber: Grenzebach Maschinenbau GmbH, 86663 Asbach-Bäumenheim (DE)
(72) Erfinder: FIUKOWSKI, Joerg, 04860 Thorgau (DE); KLEIDEITER, Gerd, 48683 Ahaus (DE)
(74) Vertreter: Kindermann, Peter
(86) Internationale Anmeldenummer: PCT/DE2017/000348
(87) Internationale Veröffentlichungsnummer: WO 2018/072774

(56) Entgegenhaltungen:
- DE-A1-102004 014 323
- DE-A1-102012 109 691
- US-A1- 2007 181 417
- US-A1- 2011 038 187
- US-A1- 2014 231 243
- US-A1- 2015 021 167

## Beschreibung

Die Erfindung betrifft eine Vorrichtung und ein Verfahren zur Herstellung definierter Eigenschaften von Gradientenschichten in einem System mehrlagiger Beschichtungen bei Sputter-Anlagen.

Die magnetfeldunterstützte Kathodenzerstäubung (Magnetron Sputtering) hat Eingang gefunden in viele Bereiche der modernen Oberflächentechnik.

Ausgehend von Anwendungen in der Mikroelektronik ist die magnetfeldunterstützte Kathodenzerstäubung heute als industrielles Beschichtungsverfahren für Architekturglas, Flachbildschirme, Brillengläser, Bandmaterialien, Werkzeug, dekorative Gegenstände und funktionelle Bauteile etabliert. Dabei werden funktionelle Bauteile oft mit Korrosionsschutz oder Hartstoffschichten aus Nitriden wie TiN, TaN, VN, ZrN oder Karbonitriden wie TiCN in Ein- oder Mehrlagentechnik versehen. Zunehmend finden auch superharte Schichten auf Basis von Nano-Mehrlagenschichten mit Härtewerten bis zu 50 GPa Anwendung. In der Automobilindustrie sind reibungs- und verschleißmindernde Metall-Kohlestoff Schichten bestens bewährt.

Die größten Vakuum-Beschichtungsanlagen, und damit oftmals auch die Anlagen mit dem höchsten Energiebedarf, sind die typischen horizontalen In-Line-Anlagen für die Architekturglas-Beschichtung.

Aus der DE 103 56 357 B4 ist zum Stand der Technik ein wärmebehandelbares Sonnen- und Wärmeschutzschichtsystem und ein Verfahren zu dessen Herstellung bekannt. Dieser Druckschrift liegt die Aufgabe zugrunde, ein mittels Vakuumbeschichtung auf Glas aufbringbares Sonnenschutzsystem und ein Verfahren zu dessen Herstellung darzustellen, welches variabel wärmebehandelbar ist und dabei unter Beibehaltung der chemischen und mechanischen Beständigkeit keine sichtbare Farbverschiebung aufweist.

Der Anspruch 1 betrifft hierbei ein wärmebehandelbares und mittels Vakuumbeschichtung auf Glas aufbringbares Sonnen- und Wärmeschutzsystem welches zumindest eine Metallschichtanordnung sowie jeweils eine unterhalb davon positionierte, angrenzende untere und eine oberhalb davon positionierte, obere dielektrische Schichtanordnung aufweist. Gekennzeichnet ist dieses System dadurch, dass sowohl zumindest eine Metallschichtanordnung (4) als auch zumindest eine obere (2) und zumindest eine untere (3), dielektrische Schichtanordnung als Mehrschichtanordnung ausgeführt sind, in welcher innerhalb der Metallschichtanordnung (4) eine aus zumindest einer Einzelschicht bestehende Metallschicht (8) von einer oberen (9) und einer unteren (7) Zwischenschicht aus dem unterstöchiometrischen nitridierten oder oxidierten Metall der Metallschicht (8) eingebettet ist und in welcher sowohl die untere (3) als auch die obere (2) dielektrische Schichtanordnung eine stöchiometrische Schicht (5,11) eines Metalloder Halbleiteroxids oder Metall- oder Halbleiternitrids oder eines Nitrids, Oxids oder Oxynitrids von Silizium aufweisen.

Aus der Druckschrift DE 10 2012 109691 A1 ist ein Beschichtungssystem zum Aufbringen mehrlagiger Beschichtungen auf einem Substrat mittels Kathodenzerstäubung bekannt, wobei zur Ausbildung einer Cermet-Gradientenschicht ein Doppeltarget bestehend aus einem keramischen und einem metallischen Target verwendet wird. Hinsichtlich der Ansteuerung wird auf ein DC- (Gleichstrom) und gepulstes MF- (Mittelfrequenz) Sputtern verwiesen.

Ferner offenbart die Druckschrift US 2014/0231243 A1 eine verlustlose Überspannungsbeschaltung für Sputteranlangen, mit der ein schnellerer Stromanstieg realisiert werden kann. Hierbei werden bipolare Gleichstrom-Spannungsimpulse überhöht, wodurch sich der schnellere Stromanstieg ergibt.

Aus der WO 2013/083238 A1 ist ein reaktiver Sputterprozess bekannt. Dieser betrifft nach den Angaben im Anspruch 1 ein Verfahren zum reaktiven Sputtern bei dem mittels lonenbeschuss Material aus der Oberfläche eines ersten Targets herausgeschlagen wird und in die Gasphase übergeht, wobei an das Target pulsweise negative Spannung dergestalt angelegt wird dass es an der Targetoberfläche zu einem elektrischen Strom mit einer Stromdichte von größer als 0,5 A/cm2 kommt so dass das in die Gasphase übergehende Material zumindest teiweise ionisiert ist und bei dem ein Reaktivgasfluss aufgebaut wird und Reaktivgas mit dem Material der Targetoberfläche reagiert, dadurch gekennzeichnet, dass die Dauer eines Spannungspulses so gewählt wird, das während des Spannungspulses die Targetoberfläche an der oder den Stellen an denen der Strom fließt die meiste Zeit zumindest teilweise mit einer Verbindung aus Reaktivgas und Targetmaterial bedeckt ist und diese Bedeckung am Ende des Spannungspulses geringer ist als am Anfang des Spannungspulses und somit die Targetoberfläche am Ende des Spannungspulses in einem zweiten Zwischenzustand ist. Weiterer relevanter Stand der Technik ist offenbart in Patentdokument US 2007/068794 A1.

Bei diesem bekannten Verfahren ist die Leistungsdichte sehr hoch, was die Anforderungen an die Kühlung relativ stark erhöht. Außerdem ist die Variabilität des Gradienten einer eventuellen Schutzschicht sehr eingeschränkt.

Der vorliegenden Erfindung liegt die Aufgabe zugrunde, ein Beschichtungssystem zum Aufbringen mehrlagiger Beschichtungen sowie ein zugehöriges Verfahren zu schaffen, wobei eine Variabilität eines Gradienten einer abgeschiedenen Schicht präzise, energiesparend und auf einfache Weise zu erreichen ist. Erfindungsgemäß wird diese Aufgabe hinsichtlich der Vorrichtung durch die Merkmale des neuen Patentanspruchs 1 und hinsichtlich des Verfahrens durch die Maßnahmen des neuen Patentanspruchs 5 gelöst.

Die erfindungsgemäße Vorrichtung wird im Folgenden näher beschrieben.

Es zeigen im Einzelnen:
Fig.1: den prinzipiellen Aufbau eines Schichtstapels,
Fig.2: eine Darstellung einer herkömmlichen Beschichtungsstation,
Fig.3 die Darstellung einer erfindungsgemäßen Beschichtungsstation,
Fig.4: den typischen Signalverlauf eines erfindungsgemäß verwendeten Pulsgenerators
Fig.5: einige Beispiele über Ersatzmöglichkeiten herkömmlicher Anlagen

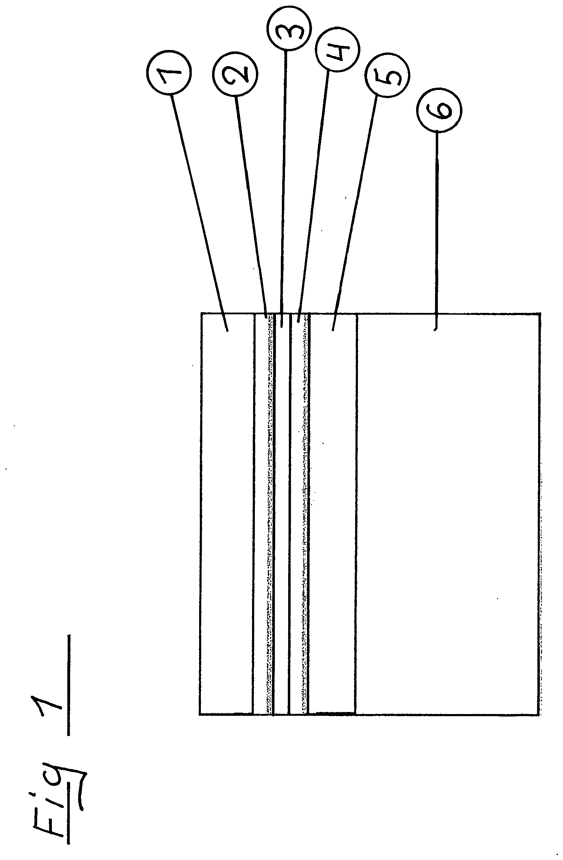

Fig.1 zeigt den prinzipiellen Aufbau eines Schichtstapels einer Niedrigenergie - Beschichtung eines Substrats, zum Beispiel einer Glasfläche als eine einfache Silberschicht ( Single Low - E ) für die verbesserte Wärmedämmung in Fenstern. Diese Beschichtungen werden typischerweise nicht nur auf Glassubstraten aufgebracht sondern auch auf Folien. Neben den typischen Schichtstapeln die nur eine reflektierende Einzelschicht ( Silberschicht, meist aus Ag ) enthalten, gibt es auch qualitativ hochwertige Mehrfachsysteme die zwei, drei oder mehrere reflektierende Einzelschichten ( Silberschichten, Ag ) enthalten ( sog. Double - Low - E oder Triple - Low - E). Diese Beschichtungen, sowie deren temperbare Beschichtungen werden mittlerweile mit graduierten asymmetrischen Metall - Schutzschichten ( sogenannte Blocker) ausgestattet..

Bei diesen Schichtstapeln erhöht sich dann entsprechend der Anzahl der Schutzschichten die Anzahl der dielektrischen Schichten. Auf das eigentliche Substrat, beispielsweise eine zu beschichtende Glasfläche 6, folgt eine dielektrische Grundschicht 5.Diese Grundschicht 5 kann aus mehreren dielektrischen Materialien zusammengesetzt sein. Auf diese Grundschicht wird eine untere Blockierschicht 4 aufgebracht. Auf diese Blockierschicht 4 wird eine metallische Funktionsschicht 3, beispielsweise aus Silber, Golf oder Kupfer aufgebracht, worauf eine obere Blockierschicht 2 folgt. Den Abschluss bildet meist eine dielektrische Außenschicht 1. Diese Außenschicht 1 kann aus mehreren dielektrischen Materialien zusammengesetzt sein. Optional kann auf die dielektrische Außenschicht 1 eine abschließende Schutzschicht ( Top - Coat ) aufgebracht werden.

Um die angestrebten Eigenschaften der metallischen Funktionsschicht 3 zu erreichen, bzw. zu sichern, müssen die Blockierschichten 2 und 4 weitestgehend metallisch und wenig reaktiv im Kontakt mit der Funktionsschicht 3 sein. Das wird durch die Zugabe von Sauerstoff und / oder Stickstoff erreicht.

In der Regel wird hierbei als Metall Silber verwendet. Die einzelnen Beschichtungsstationen sind symmetrisch aufgebaut. Der Schichtstapel enthält immer eine Metallschicht die geschützt werden muss vor den unmittelbar folgenden reaktiven Abscheidungsprozessen und für den anschließenden Temperprozess. Die Blockierschichten 2 und 4 erhöhen darüber hinaus die mechanische und chemische Stabilität ( Haftung und Korrosion ) des Schichtstapels. Auch dafür haben sich gradierte Schutzschichten als vorteilhaft erwiesen. Das heißt, die Struktur ( Stöchiometrie ) der jeweiligen Schutzschicht ändert sich mehr oder weniger mit der Dicke der Schutzschicht.

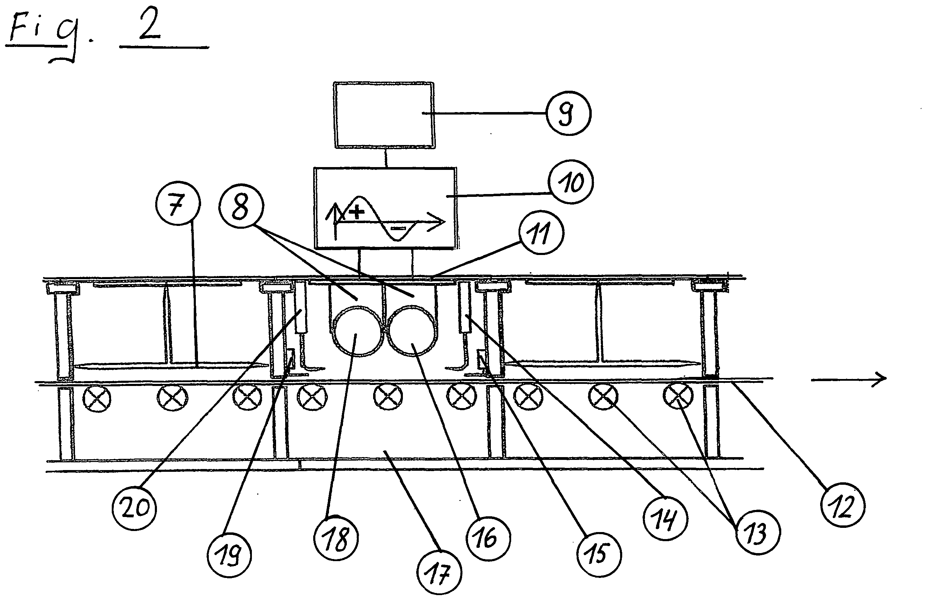

Fig.2 zeigt eine Darstellung des Aufbaus einer herkömmlichen Beschichtungsstation in Kompartmentbauweise.

Als Basis dient hier ein Kessel 17 der mit einem Kesseldeckel 11 versehen ist und in dem auf Transportrollen 13 das jeweilige Substrat 12 befördert wird. In der ersten und in der letzten Kammer gleitet das Substrat 12 in einem, von einem Tunneldeckel 7 abgedeckten, verringerten Raum. In der mittleren Kammer sind am Kesseldeckel ( Kathodendeckel ) 11 eine linke Kathode 18 und eine rechte Kathode 16 an jeweils einem Lagerblock 8 , hier als Rohrkathode ausgeführt, angebracht. Weiter sind in dieser Kammer der linke Gaseinlasskanal 19 und der rechte Gaseinlasskanal 15, sowie die linke Spritzblende 20 ( Sputterblende ) und die rechte Spritzblende 14 ( Sputterblende ) als Sputterprozessbereichs - Abschirmung ( Maske ) zu sehen.

Die beiden Kathoden (Dual - Kathode) werden von einer Gleichstromquelle 9 mit Energie versorgt. Dabei liefert ein typischer MF - Generator 10 einen sinusförmigen Wechselstrom mit einer Frequenz im Bereich von 10 kHz bis etwa 100 kHz.

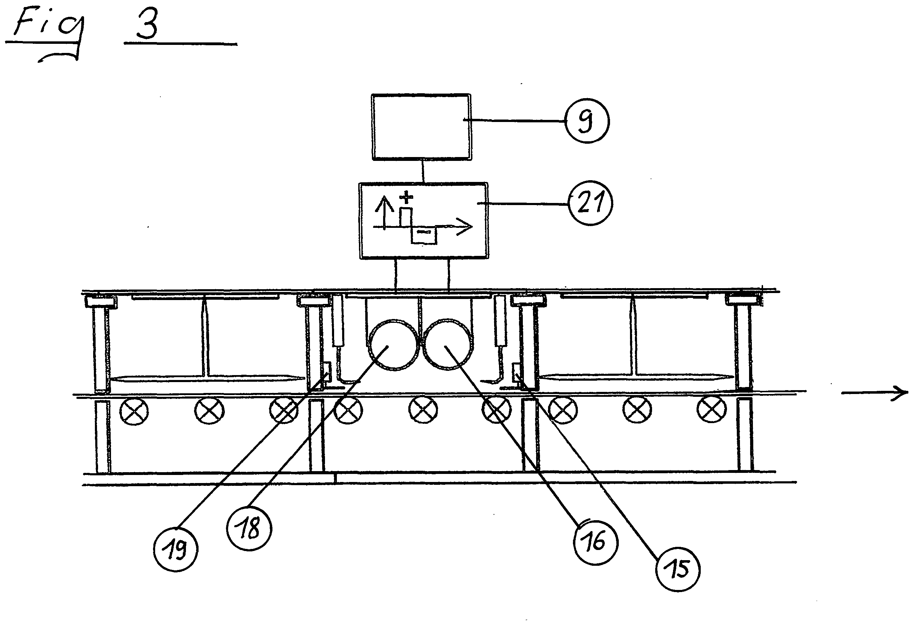

Fig.3 zeigt die Darstellung des Aufbaus der Beschichtungsstation für den erfindungsgemäßen Sputter - Vorgang.

Die Anlage nach der Fig.3 entspricht in der rein mechanischen Ausstattung der Anlage wie sie in der Fig.2 beschrieben wurde. Hier wurden deshalb lediglich der linke Gaseinlasskanal 19, der rechte Gaseinlasskanal 15 und die linke Kathode 18 und die rechte Kathode 16 ( Rohrkathode ) bezeichnet.

Die Gleichstromquelle 9 ist ebenfalls typisch für viele Sputterprozesse und wird z.B. für das Abscheiden der IR - reflektierenden Funktionsschicht ( Ag) an Einzelkathoden genutzt.

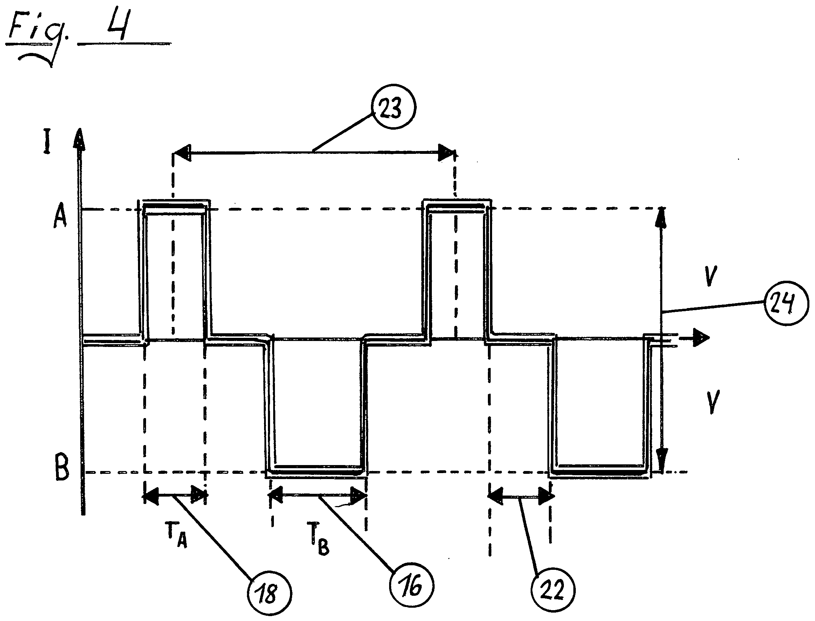

Der Unterschied zu dem in der Fig.2 dargestellten herkömmlichen Sputter - Vorgang liegt darin, dass der von einer Gleichstromquelle 9 gelieferte Gleichstrom von einem Pulsgenerator 21 in einen so genannten bi - polaren Puls verwandelt wird, wie er in der Fig.4 beschrieben wird.

Fig.4 zeigt den typischen Signalverlauf eines erfindungsgemäß verwendeten bi - polaren Pulsgenerators.

Ein solcher Pulsgenerator 21 ist in der Lage in einer Pulsperiode zwei verschiedene pulsartige Spannungsverläufe zu erzeugen und diese jeweils auf eine der beiden Kathoden zu schicken. Hierbei kann die Pulsbreite unabhängig voneinander in der Breite variiert werden. Das bedeutet, dass mit dem erfindungsgemäßen Verfahren die Beschichtungs - Energie während einer Pulsperiode nach Belieben auf die beiden Kathoden 18 und 16 verteilt werden kann. Die von der Gleichstromquelle 9 gelieferte Energie kann somit auf beide Kathoden im Bereich zwischen 5% und 95% verteilt werden.

In der Fig.4 ist beispielhaft der linke ( positive ) Puls der linken Kathode 18 und der rechte ( negative ) Puls der rechten Kathode 16 zugeordnet, wobei die jeweilige Pulsbreite im Wesentlichen dem jeweiligen Energieanteil der auf beide Kathoden gelieferten Gesamtenergie einer Pulsperiode entspricht.

Eine Pulsperiode ist in der Fig.4 mit 23 bezeichnet, wobei hier auch ersichtlich ist, dass in den Pulspausen auf keine der beiden Kathoden Energie geliefert wird. Eine solche Pulspause ist in der Fig.4 mit Leerlauf 22 ( Time off ) bezeichnet.

Die von der Gleichstromquelle 9 gelieferte Spannung 24 kann bis zu 1000 Volt und mehr betragen, so dass sich die Spannungshöhe jedes Pulses im Bereich zwischen U= -1000 V und U= + 1000 V ergibt.

Mit der beschriebenen Vorrichtung ist es nicht nur möglich gradierte Schichten in nahezu beliebiger Abstufung zu erzeugen, sondern auch stark strukturierte Schichtaufbauten herzustellen ohne die Beschichtungsanlage in ihrem generellen Aufbau zu verändern.

Während es bei herkömmlichen Anlagen für die Erzeugung gradierter Schichten notwendig ist, dass die beiden Gaseinlässe 19 und 15 asymmetrisch betrieben werden, das heißt, dass beide Gaseinlässe mit unterschiedlichen Gaszufuhren betrieben werden, was die Qualität der Beschichtung und die Regelbarkeit beeinträchtigt, wird die Art und die Dicke der Bereiche der zusammengesetzten, ineinander verlaufenden (gradierten) Beschichtung erfindungsgemäß über den Pulsgenerator gesteuert.

Bei herkömmlichen Beschichtungsanlagen sind zur Erzeugung gradierter Schichten mehrere Beschichtungsstationen erforderlich. Außerdem ist die Variabilität des Gradienten extrem eingeschränkt und eine Veränderung von Einstellungen erfordert meist den Umbau der gesamten Anlage. Die erfindungsgemäße bi - polare Pulssteuerung macht all dies nicht nur überflüssig, sondern erweitert auch die Möglichkeiten der gesamten Beschichtungstechnik.

Die Applikation der Pulssteuerung für eine Gradientenschicht erlaubt es auch sensible Leistungsbereiche ( Niedrigenergieeintrag auf die Funktionsschicht ) mit einem Gradienten der oberen Blockerschicht auszuführen.

Damit kann man die Beeinträchtigung der Eigenschaften der Funktionsschicht durch zu hohen Energieeintrag vermeiden. Das heißt, die Anlage kann bis zu 30% Prozessenergie einsparen. Auch wird die Anlage im Aufbau vereinfacht und spart somit Herstellungs - und Energiekosten. Durch die Energieeffizienz wird der CO2 - Ausstoß reduziert.

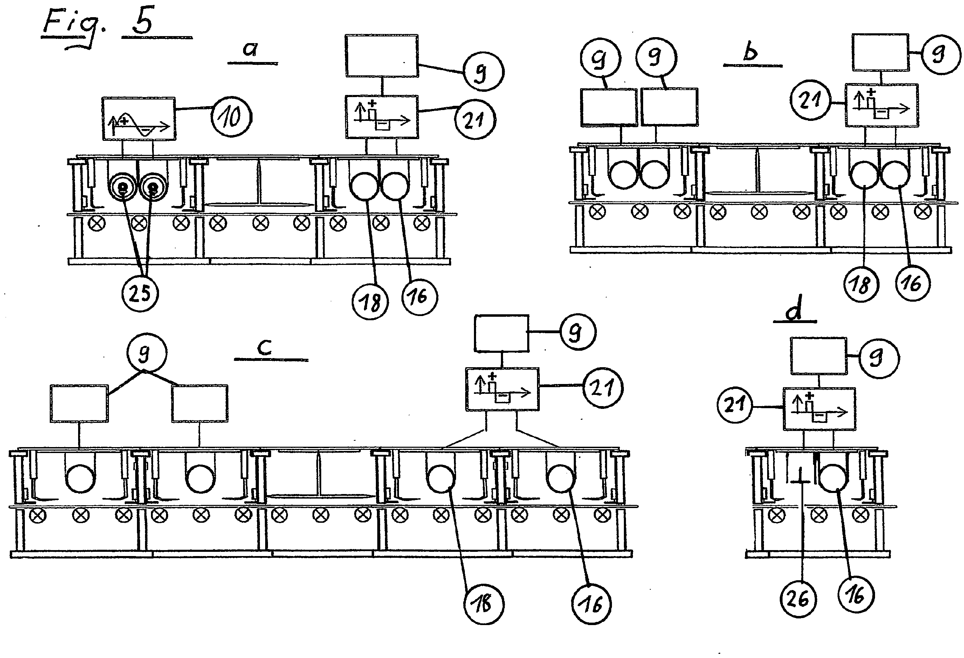

Fig.5 zeigt einige Beispiele über Ersatzmöglichkeiten herkömmlicher Anlagen.

So ist in der Fig. 5a eine herkömmliche Anlage für Beschichtungen mit einer Mittelfrequenz ersetzt durch eine Beschichtungsanlage mit bi - polarer Impulssteuerung Die duale Rotationskathode ( Dual Magnetron ) mit Magnetbar 25 entspricht der herkömmlichen Form in allgemeiner Anwendung.In der Fig.5b ist eine herkömmliche Anlage, die mittels zweier Gleichstromquellen betrieben wird, ersetzt durch eine Beschichtungsanlage mit bi - polarer Impulssteuerung.

In der Fiq.5c ist eine herkömmliche Anlage, die mittels zweier separater Gleichstromquellen betrieben wird, ersetzt durch eine Beschichtungsanlage mit jeweils einer separaten bi - polaren Impulssteuerung.

Die Fig. 5d zeigt eine Kombination von einer Planarkathode 26 und einer Rohrkathode 16. So können die Darstellungen der Fig.5a, Fig.5b, und Fig.5c auch mit Planarkathoden 26 und / oder mit Kombinationen in der, in der Fig. 5c gezeigten, Variante ausgestattet werden. Über den Kathoden können auch je nach Prozess , zur Effizienzsteigerung ( aus Gründen der Übersichtlichkeit hier nicht näher bezeichnet), Turbomolekular-Pumpen angeordnet sein.

### Bezugszeichenliste

- 1: Dielektrische Außenschicht
- 2: äußere Blockierschicht
- 3: Silberschicht (Gold oder Kupfer)
- 4: Untere Blockierschicht
- 5: dielektrische Grundschicht (Innenschicht)
- 6: Substrat, zum Beispiel Glas
- 7: Tunneldeckel
- 8: Kathoden - Lagerbock
- 9: DC - Quelle
- 10: MF - Generator ( MF = Mittelfrequenz )
- 11: Kesseldeckel
- 12: Substrat
- 13: Transportrollen
- 14: rechtes Spritzblech, Sputter - Bereichsabschirmung
- 15: rechter Gaseinlass
- 16: rechte Kathode
- 17: Kessel, Wanne
- 18: linke Kathode
- 19: linker Gaseinlass
- 20: linke Spritzblende
- 21: Pulsgenerator
- 22: Leerlauf (time off )
- 23: eine Periode, 2 Frequenzen
- 24: Spannung (1000 Volt
- 25: Magnetbar

## Patentansprüche

1. Beschichtungs-System zum Aufbringen mehrlagiger Beschichtungen auf einem Substrat mittels Kathodenzerstäubung, mit den folgenden Merkmalen:
a) ein in einem gemeinsamen Prozessraum angeordnetes Kathodenpaar (16, 18; 26), bestehend aus einem ersten Kathodenkörper (16) und einem zweiten Kathodenkörper (18; 26), wird mittels einer gemeinsamen Stromversorgung (9) mit Gleichstrom versorgt, wobei der Gleichstrom vor dem Eintritt in den Prozessraum in eine Impulsfolge mit abwechselnd positiven und negativen Impulsen mit zwischenliegenden Impulspausen umgewandelt wird,
b) eine Anordnung (21) zur Steuerung der Dauer (T_{A}, T_{B}) der einzelnen Impulse und der Dauer (22) der jeweiligen Impulspausen,
c) eine Anordnung zur Justierung der beiden Kathoden (16, 18; 26) in der Weise, dass sich ein gemeinsamer Abscheidebereich auf dem zu beschichtenden Substrat (6; 12) ergibt,
d) ein gemeinsames Prozessgas-System das die Grundversorgung des Prozessgases liefert, wobei jedem Kathodenkörper ein separates symmetrisch angeordnetes segmentiertes Prozessgassystem zugeordnet ist,
wobei das Kathodenpaar aus Planarkathoden (26) und/oder Rohrkathoden (16, 18) besteht.

2. Beschichtungs-System nach Anspruch 1,
wobei der erste Kathodenkörper (16) mit einem anderen Targetmaterial bestückt ist als der zweite Kathodenkörper (18; 26).

3. Beschichtungs-System nach Anspruch 1 oder 2,
wobei bei der Verwendung von Kathodenkörpern in der Form von Rohren die Orientierung der Magnetfelder der einzelnen Rohrkathoden gesteuert werden kann.

4. Beschichtungs-System nach einem der vorhergehenden Ansprüche, wobei über dem Kathodenpaar (16, 18; 26) jeweils mindestens eine, bzw. mehrere Turbomolekular-Pumpen angeordnet sind.

5. Verfahren für ein Beschichtungs-System nach einem der vorhergehenden Ansprüche, wobei
der Ausgang, der den positiven Impuls liefert, mit einer der beiden Kathoden (16, 18; 26) verbunden wird,
der Ausgang, der den negativen Impuls liefert, mit der anderen der beiden Kathoden (16, 18; 26) verbunden wird, und
die Dauer (T_{A}, T_{B}) der jeweiligen Impulse variiert wird, wodurch die Dicke einer abgeschiedenen Schicht gesteuert wird.

6. Verfahren nach Anspruch 5,
wobei die Pausen (22) zwischen den einzelnen Impulsen den Beschichtungs-Prozess unterbrechen.

## Claims

1. Coating system for applying multilayered coatings to a substrate by means of cathode sputtering, comprising the following features:
a) a cathode pair (16, 18; 26) arranged in a common processing chamber, consisting of a first cathode body (16) and a second cathode body (18; 26), is supplied with direct current by means of a common power supply (9), wherein the direct current is converted before the entry into the processing chamber into a pulse sequence having alternating positive and negative pulses with interposed pulse pauses,
b) an arrangement (21) for controlling the duration (T_{A}, T_{B}) of the individual pulses and the duration (22) of the respective pulse pauses,
c) an arrangement for adjusting the two cathodes (16, 18; 26) in such a manner that a common deposition region results on the substrate (6; 12) to be coated,
d) a common process gas system, which supplies the basic supply of the process gas, wherein a separate symmetrically arranged segmented process gas system is associated with each cathode body,
wherein the cathode pair consists of planar cathodes (26) and/or tubular cathodes (16, 18).

2. Coating system according to Claim 1,
wherein the first cathode body (16) is equipped with a different target material than the second cathode body (18; 26).

3. Coating system according to Claim 1 or 2,
wherein, if cathode bodies in the form of tubes are used, the orientation of the magnetic fields of the individual tubular cathodes can be controlled.

4. Coating system according to one of the preceding claims, wherein at least one or multiple turbomolecular pumps are arranged in each case above the cathode pair (16, 18; 26).

5. Coating system according to one of the preceding claims, wherein
the output which supplies the positive pulse is connected to one of the two cathodes (16, 18; 26),
the output which supplies the negative pulse is connected to the other of the two cathodes (16, 18; 26),
the duration (T_{A}, T_{B}) of the respective pulses is varied, whereby the thickness of a deposited layer is controlled.

6. Method according to Claim 5,
wherein the pauses (22) between the individual pulses interrupt the coating process.

## Revendications

1. Système de revêtement permettant d'appliquer des revêtements multicouches sur un substrat par pulvérisation cathodique, comprenant les particularités suivantes :
a) une paire de cathodes (16, 18 ; 26), disposée dans une chambre de traitement commune et composée d'un premier corps de cathode (16) et d'un deuxième corps de cathode (18 ; 26), est alimentée en courant continu au moyen d'une alimentation électrique commune (9), le courant continu étant converti avant l'entrée dans la chambre de traitement en une séries d'impulsions comprenant des impulsions en alternance positives et négatives avec des pauses d'impulsion intermédiaires,
b) un agencement (21) servant à commander la durée (T_{A}, T_{B}) des impulsions individuelles et la durée (22) des pauses d'impulsion respectives,
c) un agencement servant à ajuster les deux cathodes (16, 18 ; 26) de telle sorte qu'il en résulte une zone de dépôt commune sur le substrat à revêtir (6 ; 12),
d) un système de gaz de process commun qui fournit l'alimentation de base du gaz de process, dans lequel un système de gaz de process séparé segmenté, disposé de manière symétrique, est associé à chaque corps de cathode,
dans lequel la paire de cathodes est composée de cathodes planaires (26) et/ou de cathodes tubulaires (16, 18).

2. Système de revêtement selon la revendication 1, dans lequel le premier corps de cathode (16) est équipé d'un autre matériau cible que le deuxième corps de cathode (18 ; 26).

3. Système de revêtement selon la revendication 1 ou 2, dans lequel, lors de l'utilisation de corps de cathode sous la forme de tubes, l'orientation des champs magnétiques des cathodes tubulaires individuelles peut être commandée.

4. Système de revêtement selon l'une quelconque des revendications précédentes, dans lequel respectivement au moins une ou plusieurs pompes turbomoléculaires est/sont disposée(s) au-dessus de la paire de cathodes (16, 18 ; 26).

5. Procédé pour un système de revêtement selon l'une quelconque des revendications précédentes, dans lequel
la sortie qui fournit l'impulsion positive est reliée à l'une des deux cathodes (16, 18 ; 26),
la sortie qui fournit l'impulsion négative est reliée à l'autre des deux cathodes (16, 18 ; 26), et
la durée (T_{A}, T_{B}) des impulsions respectives est modulée de sorte que l'épaisseur d'une couche déposée est commandée.

6. Procédé selon la revendication 5, dans lequel les pauses (22) entre les impulsions individuelles interrompent le processus de revêtement.
